# EUROPEAN PATENT APPLICATION

(11) **EP 3 144 313 A1**
(43) Date of publication of application: **22.03.2017**
(21) Application number: 15792769.0
(22) Date of filing: 31.03.2015
(51) Int. Cl.: C07F 15/06, C23C 16/18, H01L 21/316

(54) **COBALT COMPOUND, RAW MATERIAL FOR FORMING THIN FILM, AND METHOD FOR PRODUCING THIN FILM**

(30) Priority: 14.05.2014 JP 2014100607
(71) Applicant: Adeka Corporation, Tokyo 116-8554 (JP)
(72) Inventor: YOSHINO, Tomoharu, Tokyo 116-8554 (JP); ENZU, Masaki, Tokyo 116-8554 (JP); SAKURAI, Atsushi, Tokyo 116-8554 (JP); HATASE, Masako, Tokyo 116-8554 (JP); UCHIUZOU, Hiroyuki, Tokyo 116-8554 (JP); NISHIDA, Akihiro, Tokyo 116-8554 (JP)
(74) Representative: Kador & Partner
(86) International application number: PCT/JP2015/060131
(87) International publication number: WO 2015/174153

(57) **Abstract**

The cobalt compound of this invention is represented by general formula (I) below. In general formula (I), R¹ to R³ independently represent a straight chain or branched alkyl group having 1 to 5 carbon atoms. In addition, the thin film-forming raw material of this invention contains the cobalt compound represented by general formula (I). According to this invention, it is possible to provide a cobalt compound which can be transported in the form of a liquid due to having a low melting point, which can be decomposed at a low temperature and which can be easily vaporized due to having a high vapor pressure; and a thin film-forming raw material that uses this cobalt compound.

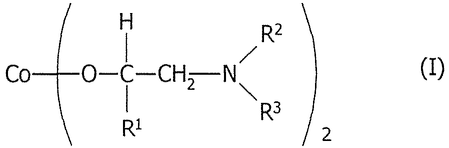

## Description

### TECHNICAL FIELD

This invention relates to a cobalt compound and a thin film-forming raw material that are used in electrode film, resistive film, adhesive film, magnetic tape, ultra-hard tool members, and the like; and a method for producing a thin film.

### BACKGROUND ART

Cobalt-containing thin films are used in electrode films, resistive films, adhesive films, magnetic tapes, ultra-hard tool members, and the like. Methods for producing such thin films include flame hydrolysis deposition methods; sputtering methods; ion plating methods; MOD (Metal Organic Decomposition) methods such as coating thermodecomposition methods and sol gel methods; and vapor phase thin film formation methods such as ALD (Atomic Layer Decomposition) methods and CVD (Chemical Vapor Decomposition) methods. Of these, vapor phase thin film formation methods have many advantages, such as excellent compositional control properties and step coverage properties, suitability for mass production and enabling of hybrid integration, and are therefore optimal production methods.

In MOD methods and vapor phase thin film formation methods, cobalt compounds having organic ligands are used as precursors which are contained in thin film-forming raw materials and which supply cobalt atoms to thin films. For example, Patent Documents 1 and 2 each report a cobalt compound in which a tertiary aminoalkoxide is contained as a ligand. In addition, Patent Document 3 reports a cobalt compound that contains a primary aminoalkoxide as a ligand.

### REFERENCES

### PATENT DOCUMENTS

Patent Document 1: KR 10-0675983 B
Patent Document 2: US 2010/0181566 A
Patent Document 3: WO 2007/147020

### DISCLOSURE OF THE INVENTION PROBLEMS TO BE SOLVED BY THE INVENTION

Among a variety of methods for producing thin films, in vapor phase thin film formation methods in particular, precursors used in thin film-forming raw materials need to satisfy the requirements of being able to be transported in the form of a liquid due to having a low melting point, being able to be decomposed at a low temperature and being easily vaporized due to having a high vapor pressure. However, the cobalt compounds disclosed in Patent Documents 1 to 3 do not adequately meet these requirements.

This invention has been developed in order to solve problems such as those mentioned above, and has the objective of providing a cobalt compound which can be transported in the form of a liquid due to having a low melting point, which can be decomposed at a low temperature and which can be easily vaporized due to having a high vapor pressure; and a thin film-forming raw material that uses this cobalt compound.

Another objective of this invention is to provide a thin film production method by which a high quality cobalt-containing thin film can be produced with good productivity.

### MEANS FOR SOLVING THE PROBLEMS

As a result of diligent research, the inventors of this invention found that a cobalt compound having an aminoalcohol with a specific structure as a ligand could solve the problem mentioned above, and thereby completed this invention.

That is, this invention is a cobalt compound represented by general formula (I): 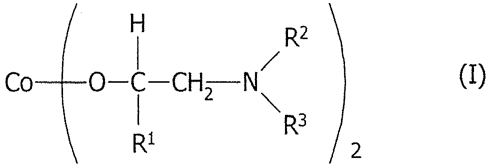 wherein R¹ to R³ independently represent a straight chain or branched alkyl group having 1 to 5 carbon atoms.

In addition, this invention is a thin film-forming raw material, comprising the cobalt compound mentioned above.

Furthermore, this invention is a method for producing a thin film, the method including the steps of vaporizing the thin film-forming raw material according to claim 2 to obtain a cobalt compound-containing vapor; and contacting the vapor with a substrate to decompose and/or chemically react the cobalt compound and then to form a thin film on the substrate.

### EFFECTS OF THE INVENTION

According to this invention, it is possible to provide a cobalt compound which can be transported in the form of a liquid due to having a low melting point, which can be decomposed at a low temperature and which can be easily vaporized due to having a high vapor pressure; and a thin film-forming raw material that uses this cobalt compound.

According to this invention, it is also possible to provide a thin film production method by which a high quality cobalt-containing thin film can be produced with good productivity.

### BRIEF DESCRIPTION OF THE DRAWINGS

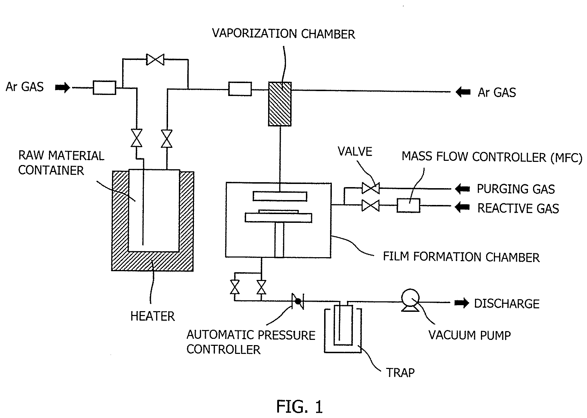

Fig. 1 is a schematic view of a CVD apparatus which is used in the thin film production method of this invention and which is used in Example 8.

### BEST MODE FOR CARRYING OUT THE INVENTION

Preferred embodiments of the cobalt compound, thin film-forming raw material and method for producing a thin film of this invention will now be explained in detail.

The cobalt compound of this invention is represented by general formula (I).

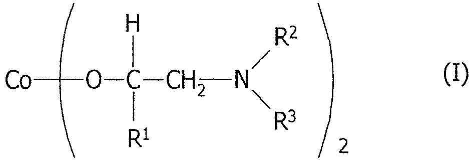

In general formula (I), R¹ to R³ independently represent a straight chain or branched alkyl group having 1 to 5 carbon atoms. Straight chain or branched chain alkyl groups having 1 to 5 carbon atoms represented by R¹ to R³ are not particularly limited, but examples thereof include methyl groups, ethyl groups, propyl groups, isopropyl groups, butyl groups, isobutyl groups, secondary butyl groups, tertiary butyl groups, pentyl groups, amyl groups and isoamyl groups. In addition, a cobalt compound represented by general formula (I) may have an optically active site, but in such cases, the cobalt compound may be the R isomer, the S isomer or a mixture containing the R isomer and S isomer at arbitrary proportions. In cases where a cobalt compound is a mixture of the R isomer and S isomer, the use of a racemate is particularly preferred from the perspective of production costs.

A cobalt compound having a structure such as that described above can be transported in the form of a liquid due to having a low melting point, can be decomposed at a low temperature and can be easily vaporized due to having a high vapor pressure.

In addition, a cobalt compound may form a ring structure when a nitrogen atom in a ligand coordinates to the cobalt atom, as shown in general formula (II) below. Moreover, the present specification discloses a concept in which a cobalt compound represented by general formula (I) includes a cobalt compound represented by general formula (II).

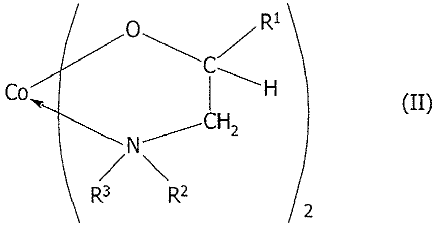

In general formula (II), R¹ to R³ independently represent a straight chain or branched alkyl group having 1 to 5 carbon atoms.

When using a vapor phase thin film formation method in which a thin film is formed by vaporizing a cobalt compound, it is preferable for the cobalt compound to have the characteristics of being a liquid at ordinary temperature and pressure or having a low melting point in the case of a solid, being able to be decomposed at a low temperature and having a high vapor pressure, but cobalt compounds having structures such as that described above generally exhibit such characteristics. In particular, a cobalt compound in which in general formula (I), R¹ is a methyl group or an ethyl group, and R² and R³ are each independently a straight chain or branched chain alkyl group having 1 to 5 carbon atoms and a cobalt compound in which in general formula (I), R¹ is an isopropyl group, an isobutyl group, a secondary butyl group or a tertiary butyl group, R² and R³ are each independently a straight chain or branched chain alkyl group having 1 to 5 carbon atoms and the total number of carbon atoms in R² and R³ is 3 or higher exhibit the characteristic of having a particularly low melting point. In addition, a cobalt compound in which in general formula (I), R¹ is a methyl group, an ethyl group, an isopropyl group, an isobutyl group or a secondary butyl group, R² and R³ are each independently a straight chain or branched chain alkyl group having 1 to 3 carbon atoms and the total number of carbon atoms in R² and R³ is 3 or 4 and a cobalt compound in which in general formula (I), R¹ is a tertiary butyl group, R² and R³ are each independently a straight chain or branched chain alkyl group having 1 to 4 carbon atoms and the total number of carbon atoms in R² and R³ is 4 or 5 exhibit the characteristics of having a particularly low melting point and being more readily decomposed at a low temperature. Furthermore, a cobalt compound in which R¹ is an isopropyl group, R² is a methyl group and R³ is an ethyl group and a cobalt compound in which R¹ is a tertiary butyl group, R² is an ethyl group and R³ is an ethyl group exhibit the characteristic of being more readily decomposed at a low temperature.

Meanwhile, in cases where a film formation method involving a MOD method is used, it is preferable for the cobalt compound to exhibit the characteristic of excellent solubility in the solvent being used, and the like, but cobalt compounds having structures such as those described above exhibit such a characteristic. Cobalt compounds that are particularly suitable for MOD methods can be easily obtained by appropriately selecting R¹ to R³ in general formula (I) according to the type of solvent being used, the thin film formation reaction, and the like.

Specific examples of cobalt compounds of this invention include Compounds No. 1 to No. 30 given below. However, the cobalt compound of this invention is in no way limited to the compounds exemplified below. Moreover, in the chemical formulae given below, "Me" denotes a methyl group, "Et" denotes an ethyl group, "iPr" denotes an isopropyl group, "iBu" denotes an isobutyl group, "sBu" denotes a secondary butyl group, and "tBu" denotes a tertiary butyl group.

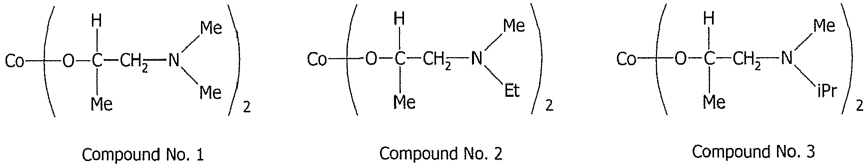

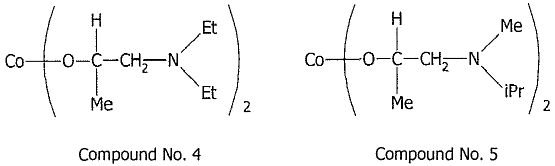

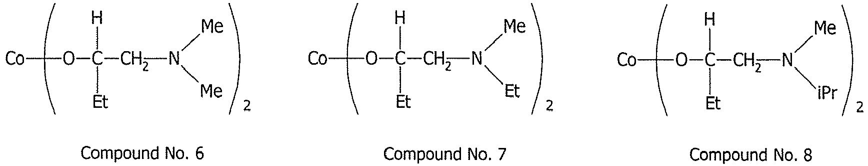

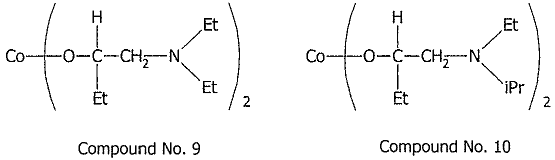

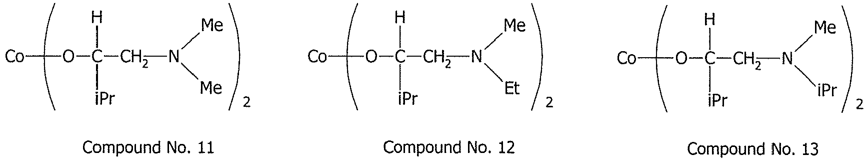

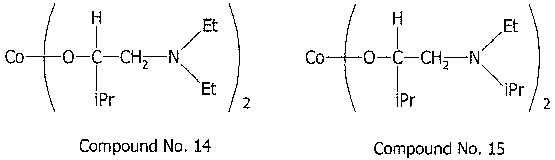

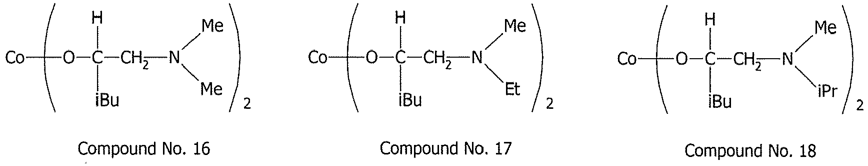

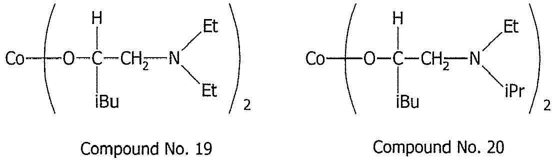

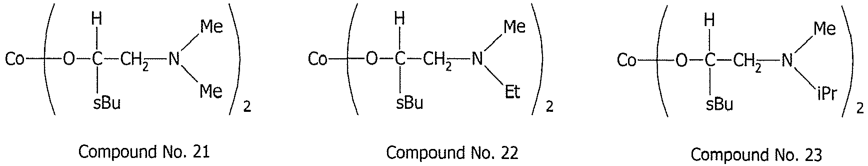

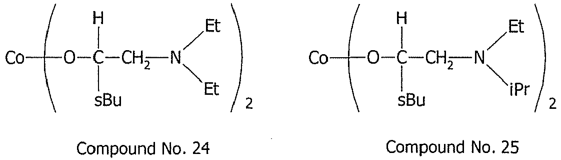

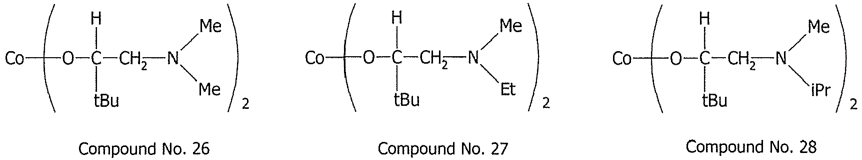

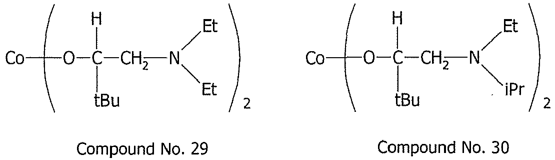

The method for producing a cobalt compound of this invention is not particularly limited, and a cobalt compound can be produced by using a well-known reaction. Specifically, the cobalt compound of this invention can be produced by using a well-known alkoxide compound synthesis method that uses an aminoalcohol. Examples thereof include a method comprising reacting an inorganic cobalt salt such as halide and nitrate, or a hydrate thereof with an aminoalcohol compound that provides a prescribed ligand in the presence of a base such as sodium, sodium hydride, sodium amide, sodium hydroxide, sodium methylate, ammonia or an amine; a method comprising reacting an inorganic cobalt salt such as halide and nitrate, or a hydrate thereof with an alkali metal alkoxide, such as a sodium alkoxide, lithium alkoxide or potassium alkoxide, of an alcohol compound that provides a prescribed ligand; a method comprising conducting an exchange reaction of a cobalt alkoxide compound of a low molecular weight alcohol, such as methoxide, ethoxide, isopropoxide and butoxide, with an alcohol compound that provides a prescribed ligand; and a method comprising reacting an inorganic cobalt salt such as halide and nitrate with a derivative that gives a reactive intermediate so as to obtain a reactive intermediate, and then reacting this reactive intermediate with an alcohol compound that provides a prescribed ligand. Here, examples of the reactive intermediate mentioned above include cobalt amide compounds such as bis(dialkylamino) cobalt compounds and bis(bis(trimethylsilyl)amino) cobalt compounds.

Cobalt compounds having characteristics such as those described above can be transported in the form of a liquid due to having a low melting point, can be decomposed at a low temperature and can be easily vaporized due to having a high vapor pressure, and are therefore suitable as thin film-forming raw materials that supply cobalt to a thin film formed using a variety of thin film production methods, and especially vapor phase thin film formation methods.

The thin film-forming raw material of this invention contains the cobalt compound of this invention, which is represented by general formula (I), as a precursor. Here, components in the thin film-forming raw material of this invention vary according to the type of thin film to be produced, but in cases where a thin film containing only cobalt as a metal is to be formed, the thin film-forming raw material of this invention contains only a cobalt compound represented by general formula (I) above as a precursor, and does not contain metal compounds other than the cobalt compound or metalloid compounds. Meanwhile, in cases where a thin film containing cobalt and metals other than cobalt and/or metalloid elements as metals is to be formed, the thin film-forming raw material of this invention contains a compound that contains a metal other than cobalt and/or a compound that contains a metalloid element (hereinafter referred to as "other precursors") in addition to a cobalt compound represented by general formula (1) above.

In cases where the thin film-forming raw material of this invention contains other precursors, the content of other precursors is preferably 0.01 to 10 moles, and more preferably 0.1 to 5 moles, relative to 1 mole of a cobalt compound represented by general formula (1) above.

In addition, the thin film-forming raw material of this invention may further contain an organic solvent and/or a nucleophilic reagent, as mentioned below.

As explained above, because the physical properties of the cobalt compound of this invention, which is a precursor, are suitable for vapor phase thin film formation methods, and especially CVD methods and ALD methods, the thin film-forming raw material of this invention is particularly useful as a raw material used in these film formation methods (hereinafter referred to as "a vapor phase thin film formation raw material").

In cases where the thin film-forming raw material of this invention is a vapor phase thin film formation raw material, the form thereof can be selected as appropriate according to techniques such as transportation and supply methods in the vapor phase thin film formation method being used.

These transportation and supply methods include gas transportation methods in which a vapor phase thin film formation raw material is vaporized by being subjected to heating and/or reduced pressure in a raw material container, and then supplied to a film formation chamber in which a substrate is provided together with a carrier gas, such as argon, nitrogen or helium, if necessary; and a liquid transportation method in which a vapor phase thin film formation raw material is transported in the form of a liquid to a vaporization chamber, vaporized in the vaporization chamber by being subjected to heating and/or reduced pressure, and then supplied to a film formation chamber in which a substrate is provided.

In the case of a gas transportation method, a vapor phase thin film formation raw material able to be vaporized by being subjected to heating and/or reduced pressure is used. Meanwhile, in the case of a liquid transportation method, a vapor phase thin film formation raw material that is in the form of a liquid at ordinary temperature and pressure is used. Therefore, in the case of a liquid transportation method, if the cobalt compound is in the form of a liquid at ordinary temperature and pressure, the liquid cobalt compound can be used as a vapor phase thin film formation raw material, but if the cobalt compound is in the form of a solid at ordinary temperature and pressure, the cobalt compound is used as a vapor phase thin film formation raw material after being dissolved in an organic solvent.

In addition, multi-component vapor phase thin film formation methods include methods in which the components are individually vaporized and supplied (hereinafter referred to as "single source methods") and methods in which a mixed raw material, which is obtained by mixing the components in advance at prescribed proportions, is vaporized and supplied (hereinafter referred to as "cocktail source methods"). In the case of a cocktail source method, a mixture of the cobalt compound of this invention and other precursors or a mixed solution obtained by adding an organic solvent to such a mixture is used as the vapor phase thin film formation raw material.

The organic solvent used in the thin film-forming raw material of this invention is not particularly limited, and ordinary organic solvents that are well known in this technical field can be used. Examples of organic solvents include acetic acid esters such as ethyl acetate, butyl acetate and methoxyethyl acetate; ether compounds such as tetrahydrofuran, tetrahydropyran, ethylene glycol dimethyl ether, di(ethylene glycol) dimethyl ether, tri(ethylene glycol) dimethyl ether, dibutyl ether and dioxane; ketone compounds such as methyl butyl ketone, methyl isobutyl ketone, ethyl butyl ketone, dipropyl ketone, diisobutyl ketone, methyl amyl ketone, cyclohexanone and methylcyclohexanone; hydrocarbon compounds such as hexane, cyclohexane, methylcyclohexane, dimethylcyclohexane, ethylcyclohexane, heptane, octane, toluene and xylene; cyano group-containing hydrocarbon compounds such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane and 1,4-dicyanobenzene; pyridine and lutidine. It is possible to use one of these organic solvents or a mixture of two or more types thereof according to the solute solubility, relationships between usage temperature, boiling point and flash point, and the like.

In cases where the thin film-forming raw material of this invention contains an organic solvent, the total quantity of the cobalt compound of this invention and other precursors in the organic solvent is preferably 0.01 to 2.0 mol/L, and more preferably 0.05 to 1.0 mol/L.

The other precursors used in the thin film-forming raw material of this invention are not particularly limited, and ordinary precursors that are well known in this technical field can be used. Examples of other precursors include compounds comprising silicon or a metal (excluding cobalt) and one or more organic coordination compounds, such as alcohol compounds, glycol compounds, β-diketone compounds, cyclopentadiene compounds, organic amine compounds and ketoimine compounds. Metal species are not particularly limited, but examples thereof include magnesium, calcium, strontium, barium, radium, scandium, yttrium, titanium, zirconium, hafnium, vanadium, niobium, tantalum, chromium, molybdenum, tungsten, manganese, iron, osmium, ruthenium, rhodium, iridium, nickel, palladium, platinum, copper, silver, gold, zinc, cadmium, aluminum, gallium, indium, germanium, tin, lead, antimony, bismuth, lanthanum, cerium, praseodymium, neodymium, promethium, samarium, europium, gadolinium, terbium, dysprosium, holmium, erbium, thurium and ytterbium.

The alcohol compound that provides an organic ligand of another precursor is not particularly limited, but examples thereof include alkyl alcohols such as methanol, ethanol, propanol, isopropyl alcohol, butanol, sec-butyl alcohol, isobutyl alcohol, tert-butyl alcohol, pentyl alcohol, isopentyl alcohol and tertiary pentyl alcohol; ether alcohols such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-proproxy-1,1-diethylethanol, 2-s-butoxy-1,1-diethylethanol and 3-methoxy-1,1-dimethylpropanol; and aminoalcohols such as 1-dimethylamino-2-propanol, 1-ethylmethylamino-2-propanol, 1-diethylamino-2-propanol, 1-dimethylamino-2-methyl-2-propanol, 1-ethylmethylamino-2-methyl-2-propanol, 1-diethylamino-2-methyl-2-propanol, 1-dimethylamino-2-butanol, 1-ethylmethylamino-2-butanol, 1-diethylamino-2-butanol, 1-dimethylamino-2-methyl-2-butanol, 1-ethylmethylamino-2-methyl-2-butanol and 1-diethylamino-2-methyl-2-butanol.

The glycol compound that provides an organic ligand of another precursor is not particularly limited, but examples thereof include 1,2-ethane diol, 1,2-propane diol, 1,3-propane diol, 2,4-hexane diol, 2,2-dimethyl-1,3-propane diol, 2,2-diethyl-1,3-propane diol, 1,3-butane diol, 2,4-butane diol, 2,2-diethyl-1,3-butane diol, 2-ethyl-2-butyl-1,3-propane diol, 2,4-pentane diol, 2-methyl-1,3-propane diol, 2-methyl-2,4-pentane diol, 2,4-hexane diol and 2,4-dimethyl-2,4-pentane diol.

The β-diketone compound that provides an organic ligand of another precursor is not particularly limited, but examples thereof include alkyl-substituted β-diketone compounds such as acetylacetone, hexane-2,4-dione, 5-methylhexane-2,4-dione, heptane-2,4-dione, 2-methylheptane-3,5-dione and 2,6-dimethylheptane-3,5-dione; fluoro-substituted alkyl β-diketone compounds such as 1,1,1-trifluoropentane-2,4-dione, 1,1,1-trifluoro-5,5-dimethylhexane-2,4-dione, 1,1,1,5,5,5-hexafluoropentane-2,4-dione and 1,3-diperfluorohexylpropane-1,3-dione; and ether-substituted β-diketone compounds such as 1,1,5,5-tetramethyl-1-methoxyhexane-2,4-dione, 2,2,6,6-tetramethyl-1-methoxyheptane-3,5-dione and 2,2,6,6-tetramethyl-1-(2-methoxyethoxy)heptane-3,5-dione.

The cyclopentadiene compound that provides an organic ligand of another precursor is not particularly limited, but examples thereof include cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene and tetramethylcyclopentadiene.

The organic amine compound that provides an organic ligand of another precursor is not particularly limited, but examples thereof include methylamine, ethylamine, propylamine, isopropylamine, butylamine, sec-butylamine, tert-butylamine, isobutylamine, dimethylamine, diethylamine dipropylamine, diisopropylamine, ethylmethylamine, propylmethylamine, isopropylmethylamine, ethylene diamine and N,N-dimethylethylene diamine.

The ketoimine compound that provides an organic ligand of another precursor is not particularly limited, but examples thereof include products of reactions between the β-diketone compounds mentioned above and organic amine compounds. Specifically, a ketoimine compound obtained by reacting acetylacetone with N,N-dimethyl ethylene diamine in the presence of hydrogen chloride, or the like, can be used.

In cases where a single source method is used, it is preferable for the other precursors to exhibit similar thermal and/or oxidative decomposition behavior to the cobalt compound of this invention. In addition, in cases where a cocktail source method is used, it is preferable for the other precursors to exhibit similar thermal and/or oxidative decomposition behavior to the cobalt compound of this invention and for the other precursors not to be degenerated by chemical reactions during mixing.

Among the other precursors, precursors having titanium, zirconium or hafnium as a metal species are represented by general formulae (III-1) to (III-5) below.

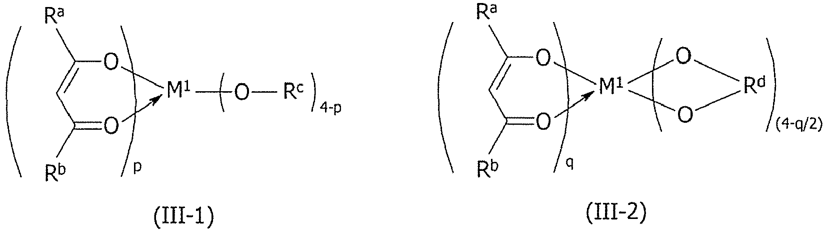

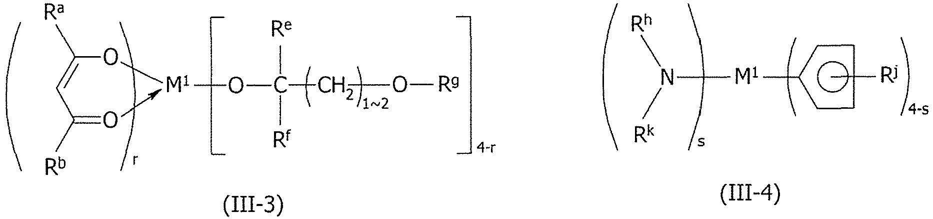

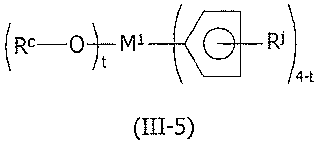

In general formulae (III-1) to (III-5), M¹ represents titanium, zirconium or hafnium, R^{a} and R^{b} independently represent an alkyl group having 1 to 20 carbon atoms, which may be substituted with a halogen atom and which may contain an oxygen atom in the chain, R^{c} represents an alkyl group having 1 to 8 carbon atoms, R^{d} represents an optionally branched alkylene group having 2 to 18 carbon atoms, R^{e} and R^{f} independently represent a hydrogen atom or an alkyl group having 1 to 3 carbon atoms, R^{g}, R^{h}, R^{k} and R^{j} independently represent a hydrogen atom or an alkyl group having 1 to 4 carbon atoms, p represents an integer between 0 and 4, q represents 0 or 2, r represents an integer between 0 and 3, s represents an integer between 0 and 4, and t represents an integer between 1 and 4.

In general formulae (III-1) to (III-5) above, examples of the alkyl group having 1 to 20 carbon atoms represented by R^{a} and R^{b}, which may be substituted with a halogen atom and which may contain an oxygen atom in the chain, include methyl groups, ethyl groups, propyl groups, isopropyl groups, butyl groups, sec-butyl groups, tert-butyl groups, isobutyl groups, amyl groups, isoamyl groups, sec-amyl groups, tert-amyl groups, hexyl groups, cyclohexyl groups, 1-methylcyclohexyl groups, heptyl groups, 3-heptyl groups, isoheptyl groups, tert-heptyl groups, n-octyl groups, isooctyl groups, tert-octyl groups, 2-ethylhexyl groups, trifluoromethyl groups, perfluorohexyl groups, 2-methoxyethyl groups, 2-ethoxyethyl groups, 2-butoxyethyl groups, 2-(2-methoxyethoxy)ethyl groups, 1-methoxy-1,1-dimethylmethyl groups, 2-methoxy-1,1-dimethylethyl groups, 2-ethoxy-1,1-dimethylethyl groups, 2-isopropoxy-1,1-dimethylethyl groups, 2-butoxy-1,1-dimethylethyl groups and 2-(2-methoxyethoxy)-1,1-dimethylethyl groups.

Examples of the alkyl group having 1 to 8 carbon atoms represented by R^{c} include methyl groups, ethyl groups, propyl groups, isopropyl groups, butyl groups, sec-butyl groups, tert-butyl groups isobutyl groups, amyl groups, isoamyl groups, sec-amyl groups, tert-amyl groups, hexyl groups, 1-ethylpentyl groups, cyclohexyl groups, 1-methylcyclohexyl groups, heptyl groups, isoheptyl groups, tert-heptyl groups, n-octyl groups, isooctyl groups, tert-octyl groups and 2-ethylhexyl groups.

In addition, the optionally branched alkylene group having 2 to 18 carbon atoms represented by R^{d} is a group that is provided by a glycol, and examples of the glycol include 1,2-ethane diol, 1,2-propane diol, 1,3-propane diol, 1,3-butane diol, 2,4-hexane diol, 2,2-dimethyl-1,3-propane diol, 2,2-diethyl-1,3-propane diol, 2,2-diethyl-1,3-butane diol, 2-ethyl-2-butyl-1,3-propane diol, 2,4-pentane diol, 2-methyl-1,3-propane diol and 1-methyl-2,4-pentane diol.

In addition, examples of the alkyl groups having 1 to 3 carbon atoms represented by R^{e} and R^{f} include methyl groups, ethyl groups, propyl groups and 2-propyl groups.

In addition, examples of the alkyl groups having 1 to 4 carbon atoms represented by R^{g}, R^{h}, R^{j} and R^{k} include methyl groups, ethyl groups, propyl groups, isopropyl groups, butyl groups, sec-butyl groups, tert-butyl groups and isobutyl groups.

Specific examples of precursors having titanium as a metal species include tetrakis(alkoxy) titanium compounds such as tetrakis(ethoxy) titanium, tetrakis(2-propoxy) titanium, tetrakis(butoxy) titanium, tetrakis(sec-butoxy) titanium, tetrakis(isobutoxy) titanium, tetrakis(tert-butoxy) titanium, tetrakis(tert-amyl) titanium and tetrakis(1-methoxy-2-methyl-2-propoxy) titanium; tetrakis(β-diketonate) titanium compounds such as tetrakis(pentane-2,4-dionate) titanium, (2,6-dimethylheptane-3,5-dionate) titanium and tetrakis (2,2,6,6-tetramethylheptane-3,5-dionate) titanium; bis(alkoxy)-bis(β-diketonate) titanium compounds such as bis(methoxy)-bis(pentane-2,4-dionate) titanium, bis(ethoxy)-bis(pentane-2,4-dionate) titanium, bis(tert-butoxy)-bis(pentane-2,4-dionate) titanium, bis(methoxy)-bis(2,6-dimethylheptane-3,5-dionate) titanium, bis(ethoxy)-bis(2,6-dimethylheptane-3,5-dionate) titanium, bis(2-propoxy)-bis(2,6-dimethylheptane-3,5-dionate) titanium, bis(tert-butoxy)-bis(2,6-dimethylheptane-3,5-dionate) titanium, bis(tert-amyloxy)-bis(2,6-dimethylheptane-3,5-dionate) titanium, bis(methoxy)-bis(2,2,6,6-tetramethylheptane-3,5-dionate) titanium, bis(ethoxy)-bis(2,2,6,6-tetramethylheptane-3,5-dionate) titanium, bis(2-propoxy)-bis(2,6,6,6-tetramethylheptane-3,5-dionate) titanium, bis(tert butoxy)-bis(2,2,6,6-tetramethylheptane-3,5-dionate) titanium and bis(tert-amyloxy)-bis(2,2,6,6-tetramethylheptane-3,5-dionate) titanium; glycoxybis (β-diketonate) titanium compounds such as (2-methylpentanedioxy)bis(2,2,6,6-tetramethylheptane-3,5-dionate) titanium and (2-methylpentanedioxy)bis(2,6-dimethylheptane-3,5-dionate) titanium; (cyclopentadienyl)tris(dialkylamino) titanium compounds such as (methylcyclopentadienyl)tris(dimethylamino) titanium, (ethylcyclopentadienyl)tris(dimethylamino) titanium, (cyclopentadienyl)tris(dimethylamino) titanium, (methylcyclopentadienyl)tris(ethylmethylamino) titanium, (ethylcyclopentadienyl)tris(ethylmethylamino) titanium, (cyclopentadienyl)tris(ethylmethylamino) titanium, (methylcyclopentadienyl)tris(diethylamino) titanium, (ethylcyclopentadienyl)tris(diethylamino) titanium and (cyclopentadienyl)tris(diethylamino) titanium; and (cyclopentadienyl)tris(alkoxy) titanium compounds such as (cyclopentadienyl)tris(methoxy) titanium, (methylcyclopentadienyl)tris(methoxy) titanium, (ethylcyclopentadienyl)tris(methoxy) titanium, (propylcyclopentadienyl)tris(methoxy) titanium, (isopropylcyclopentadienyl)tris(methoxy) titanium, (butylcyclopentadienyl)tris(methoxy) titanium, (isobutylcyclopentadienyl)tris(methoxy) titanium and (tert-butylcyclopentadienyl)tris(methoxy) titanium. Specific examples of precursors having zirconium or hafnium as a metal species include compounds obtained by replacing titanium with zirconium or hafnium in the compounds listed above as precursors that contain titanium.

In addition, among the other precursors, precursors having a rare earth element as a metal species are represented by general formulae (IV-1) to (IV-3) below.

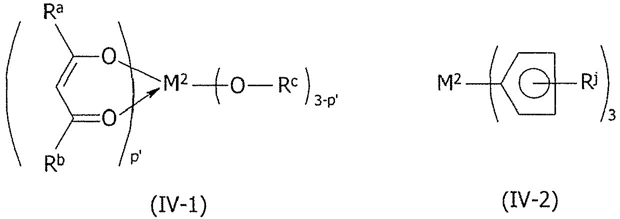

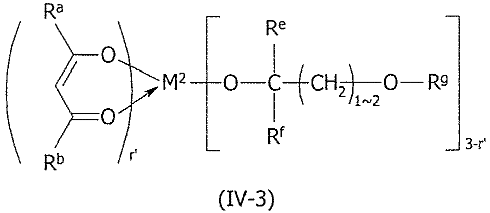

In general formulae (IV-1) to (IV-3) above, M² represents a rare earth atom, R^{a} and R^{b} independently represent an alkyl group having 1 to 20 carbon atoms, which may be substituted with a halogen atom and which may contain an oxygen atom in the chain, R^{c} represents an alkyl group having 1 to 8 carbon atoms, R^{e} and R^{f} independently represent a hydrogen atom or an alkyl group having 1 to 3 carbon atoms, R^{g} and R^{j} independently represent an alkyl group having 1 to 4 carbon atoms, p' represents an integer between 0 and 3, and r' represents and integer between 0 and 2.

In general formulae (IV-1) to (IV-3) above, examples of the rare earth atom represented by M² include scandium, yttrium, lanthanum, cerium, praseodymium, promethium, samarium, europium, gadolinium, terbium, dysprosium, holmium, erbium, thurium, ytterbium and lutetium.

In addition, examples of the groups represented by R^{a}, R^{b}, R^{c}, R^{e}, R^{f}, R^{g} and R^{j} include those groups exemplified in the precursors having titanium or the like as a metal species listed above.

If necessary, the thin film-forming raw material of this invention may contain a nucleophilic reagent in order to stabilize the cobalt compound of this invention and the other precursors. The nucleophilic reagent is not particularly limited, but examples thereof include ethylene glycol ether compounds such as glyme, diglyme, triglyme and tetraglyme; crown ether compounds such as 18-crown-6, dicyclohexyl-18-crown-6, 24-crown-8, dicyclohexyl-24-crown-8 and dibenzo-24-crown-8; polyamine compounds such as ethylene diamine, N,N'-tetramethylethylene diamine, diethylene triamine, triethylene tetramine, tetraethylene pentamine, pentaethylene hexamine, 1,1,4,7,7-pentamethyldiethylene triamine, 1,1,4,7,10,10-hexamethyltriethylene tetramine and triethoxytriethyleneamine; cyclic polyamine compounds such as cyclam and cyclene; heterocyclic compounds such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole and oxathiolane; β-keto ester compounds such as methyl acetoacetate, ethyl acetoacetate and 2-methoxyethyl acetoacetate; and β-diketone compounds such as acetylacetone, 2,4-hexane dione, 2,4-heptane dione and 3,5-heptane dione.

The usage quantity of the nucleophilic reagent is generally 0.1 to 10 moles, and preferably 1 to 4 moles, relative to 1 mole of precursor.

It is preferable for the thin film-forming raw material of this invention to contain absolutely no metal impurity elements other than the components mentioned above, halogen impurities such as chlorine impurities or organic impurities. The content of metal impurity elements is preferably 100 ppb or less, and more preferably 10 ppb or less, per element, and preferably 1 ppm or less, and more preferably 100 ppb or less, in total. In particular, in cases where the thin film-forming raw material of this invention is used to form an LSI gate insulating film, a gate film, a barrier layer, or the like, it is essential to reduce the content of alkali metal elements, alkaline earth metal elements and homologous elements, which affect the electrical characteristics of an obtained thin film. The content of halogen impurities is preferably 100 ppm or less, more preferably 10 ppm or less, and further preferably 1 ppm or less. The content of organic impurities is preferably 500 ppm or less, more preferably 50 ppm or less, and further preferably 10 ppm or less.

In addition, because moisture in the thin film-forming raw material is a cause of particle occurrence in the thin film-forming raw material and particle occurrence during film formation, as much moisture as possible should be removed before use in order to lower the moisture content in precursors, organic solvents and nucleophilic reagents. The moisture content in precursors, organic solvents and nucleophilic reagents is preferably 10 ppm or less, and more preferably 1 ppm or less.

In addition, the thin film-forming raw material of this invention preferably contains as few particles as possible in order to reduce or prevent particle contamination in an obtained thin film. Specifically, in particle measurements carried out using a liquid phase light-scattering type in-liquid particle detector, the number of particles having sizes of greater than 0.3 µm is preferably 100 or less per 1 mL of liquid phase, the number of particles having sizes of greater than 0.2 µm is more preferably 1000 or less per 1 mL of liquid phase, and the number of particles having sizes of greater than 0.2 µm is further preferably 100 or less per 1 mL of liquid phase.

The method for producing a thin film of this invention is carried out using the thin film-forming raw material of this invention. The method for producing a thin film of this invention, which is carried out using the thin film-forming raw material of this invention, is not particularly limited, and it is possible to use a MOD method such as a coating thermodecomposition method or sol gel method; a vapor phase thin film formation method such as an ALD method or CVD method, or the like. Of these, vapor phase thin film formation methods have many advantages, such as excellent compositional control properties and step coverage properties, suitability for mass production and enabling of hybrid integration.

The method for producing a thin film of this invention, which is carried out using a vapor phase film formation method, includes the steps of: vaporizing the thin film-forming raw material of this invention to obtain a cobalt compound-containing vapor; and contacting the vapor with a substrate to decompose and/or chemically react the cobalt compound and then to form a thin film on the substrate. Here, a thin film is generally formed in a film formation chamber in which a substrate is provided. In addition, a thin film may be formed by supplying a cobalt compound-containing vapor to a film formation chamber, together with a reactive gas if necessary. Furthermore, the thin film-forming raw material should be supplied to a film formation chamber, in which a substrate is provided, using a gas transportation method, a liquid transportation method, a single source method or a cocktail source method such as those explained above.

Examples of vapor phase film formation methods include thermal CVD methods in which a thin film is formed by subjecting a raw material gas (a vaporized thin film-forming raw material) or a mixture of a raw material gas and a reactive gas is subjected to a reaction using only heat; plasma CVD methods using heat and plasma; photo-CVD methods using heat and light; photo-plasma CVD methods using heat, light and plasma; and ALD methods in which a CVD deposition reaction is divided into elementary processes and deposition occurs incrementally at a molecular level.

The reactive gas that is used when necessary is not particularly limited, but examples thereof include oxidizing gases such as oxygen, ozone, nitrogen dioxide, nitrogen monoxide, water vapor, hydrogen peroxide, formic acid, acetic acid and acetic anhydride; and reducing gases such as hydrogen. In addition, in cases where a nitride-containing thin film is to be formed, an organic amine compound, such as a monoalkylamine, a dialkylamine, a trialkylamine or an alkylene diamine, hydrazine, ammonia, or the like, should be used as a reactive gas. It is possible to use one type of reactive gas or a combination of two or more types thereof.

The film formation conditions in the film formation chamber are not particularly limited, and should be set as appropriate according to the apparatus being used and the type of raw material. The apparatus used to produce the thin film is not particularly limited, and a vapor phase thin film formation apparatus that is well known in this technical field, such as an apparatus for a chemical vapor deposition method, can be used. Examples of the apparatus used to produce a thin film include a vapor phase thin film formation apparatus in which a thin film-forming raw material can be supplied as bubbles, a vapor phase thin film formation apparatus having a vaporization chamber that vaporizes a thin film-forming raw material, and a vapor phase thin film formation apparatus in which plasma treatment can be carried out. These apparatuses are not limited to single wafer type apparatuses, and may be apparatuses in which multiple wafers can be treated simultaneously by means of a batch type furnace.

Reaction temperature (substrate temperature), reaction pressure, deposition rate, and the like are generally given as examples of film formation conditions.

The reaction temperature is preferably not lower than 100°C, which is the temperature at which the cobalt compound of this invention reacts sufficiently, and more preferably 100°C to 400°C.

The reaction pressure is preferably between atmospheric pressure and 10 Pa in the case of a thermal CVD method or photo-CVD method, and preferably 2000 Pa to 10 Pa in cases where plasma is used.

The deposition rate can be controlled by adjusting raw material supply conditions (vaporization temperature and vaporization pressure), reaction temperature and reaction pressure. If the deposition rate is too high, the characteristics of the obtained thin film may deteriorate, and if the deposition rate is too low, productivity problems may occur. Therefore, the deposition rate is preferably 0.01 to 5000 nm/min, and more preferably 0.1 to 1000 nm/min. In addition, in the case of an ALD method, the number of cycles should be controlled so as to obtain the desired film thickness.

For example, in cases where a cobalt oxide thin film is to be formed using an ALD method, a precursor thin film is formed using the thin film-forming raw material of this invention. Specifically, a cobalt compound-containing vapor is obtained by vaporizing the thin film-forming raw material of this invention, and this vapor is then brought into contact with a substrate so as to subject the cobalt compound to decomposition and/or a chemical reaction and form a precursor thin film on the substrate (a precursor thin film formation step). Here, the substrate may be heated or the film formation chamber may be heated. The substrate temperature is preferably between room temperature and 500°C, and more preferably 150°C to 350°C. In addition, the pressure inside the film formation chamber is preferably 1 Pa to 10,000 Pa, and more preferably 10 Pa to 1000 Pa. The formed precursor thin film is a thin film that is generated by a part of the cobalt compound undergoing decomposition and/or a reaction, and has a composition that is different from that of the target cobalt oxide thin film.

Next, unreacted raw material gas and by-produced gas are discharged from the film formation chamber (a discharge step). It is ideal for unreacted raw material gas and by-produced gas to be completely discharged from inside the film formation chamber, but this is not necessarily essential. Examples of discharging methods include purging the film formation chamber with an inert gas such as nitrogen, helium or argon, discharging by reducing the pressure inside the film formation chamber, and combinations of these methods. In cases where the pressure inside the film formation chamber is reduced, the degree of pressure reduction is preferably 0.01 Pa to 300 Pa, and more preferably 0.01 Pa to 100 Pa.

Next, a reactive gas is supplied to the film formation chamber, and a cobalt oxide thin film is formed from the precursor thin film by the action of the reactive gas or the reactive gas and heat (a cobalt oxide thin film formation step). Here, the heating temperature is preferably between room temperature and 500°C, and more preferably 150°C to 350°C. The cobalt compound of this invention exhibits good reactivity with reactive gases such as hydrogen, oxygen and ozone, and can form a cobalt oxide thin film or cobalt thin film with good efficiency.

When using an ALD method such as that described above to produce a cobalt oxide thin film, one cycle is deemed to be one series of steps comprising the precursor thin film formation step, the discharge step and the cobalt oxide thin film formation step, and this cycle may be repeated a plurality of times until a cobalt oxide thin film having the required film thickness is obtained. In such cases, it is preferable to carry out one cycle, discharge unreacted raw material gas, reactive gas and by-produced gas from the film formation chamber in the same way as in the discharge step, and then carry out the next cycle.

In addition, in a method for producing a cobalt oxide thin film using an ALD method, energy such as plasma, light or a voltage may be applied. The timing of the energy application is not particularly limited, and energy may be applied between steps or during steps.

In addition, in the method for producing a thin film of this invention, in order to achieve superior electrical characteristics following formation of the thin film, it is possible to carry out annealing treatment in an inert atmosphere, an oxidizing atmosphere or a reducing atmosphere or carry out silicidation. In addition, in cases where step filling is required, a reflow step may be carried out. The temperature in such cases is generally 200°C to 1000°C, and preferably 250°C to 500°C.

A thin film produced using the method for producing a thin film of this invention, in which the thin film-forming raw material of this invention is used, can be a thin film of a desired type, such as a metal, an oxide ceramic, a nitride ceramic or a glass, by appropriately selecting the other precursors, the reactive gas, production conditions, and the like. Specifically, it is possible to produce a thin film of cobalt metal, a cobalt-based oxide, a cobalt-based nitride, a cobalt-based alloy such as Co-Cr, Co-Fe and Co-Ni, or the like. Examples of intended uses of these thin films include resistive films, adhesive films, ultra-hard tools, magnetic films, magnets and IC lead frames.

### EXAMPLES

This invention will now be explained in greater detail through the use of examples and comparative examples. However, this invention is not limited to the following examples, etc.

### (Example 1: Compound No. 7)

10.8 g (0.079 mol) of cobalt (II) chloride and 55.1 g of tetrahydrofuran were placed in a 200 mL four-necked flask, and stirred at room temperature. A solution obtained by diluting 25.6 g (0.167 mol) of a sodium alkoxide, which was obtained using 1-(ethyl(methyl)amino)butan-2-ol, with 48.6 g of tetrahydrofuran was added dropwise to the flask under ice cooling. Following completion of the dropwise addition, the mixed liquid was stirred at room temperature for 21 hours, 69.7 g of toluene was added and stirred, and filtration was then carried out. The target product (Compound No. 7), which was a dark purple viscous liquid, was obtained by removing the solvent from the obtained filtrate and distilling the residue at a bath temperature of 205°C, a pressure of 40 Pa and an overhead temperature of 155°C. The quantity produced was 8.23 g, and the yield was 34%.

The obtained target product (Compound No. 7) was subjected to elemental analysis (metal analysis: ICP-AES, chlorine analysis: TOX). These results are shown below.
Cobalt: 19.1 mass% (theoretical value: 18.5 mass%)
C: 51.3 mass%, H: 10.3 mass%, N: 8.5 mass% (theoretical values: C: 52.7 mass%, H: 10.1 mass%, N: 8.8 mass%)
Chlorine: Less than 10 ppm

### (Example 2: Compound No. 12)

1.13 g (8.27 mmol) of cobalt (II) chloride and 15.3 g of tetrahydrofuran were placed in a 100 mL three-necked flask, and stirred at room temperature. A solution obtained by diluting 2.90 g (17.3 mmol) of a sodium alkoxide, which was obtained using 1-(ethyl(methyl)amino)-3-methylbutan-2-ol, with 18.0 g of tetrahydrofuran was added dropwise to the flask under ice cooling. Following completion of the dropwise addition, the mixed liquid was stirred at room temperature for 21 hours and then filtered. The target product (Compound No. 12), which was a deep purple viscous liquid, was obtained by removing the solvent from the obtained filtrate and distilling the residue at a bath temperature of 145°C, a pressure of 25 Pa and an overhead temperature of 107°C. The quantity produced was 0.42 g, and the yield was 14%.

The obtained target product (Compound No. 12) was subjected to elemental analysis (metal analysis: ICP-AES, chlorine analysis: TOX). These results are shown below.
Cobalt 17.4 mass% (theoretical value: 16.7 mass%)
C: 55.9 mass%, H: 10.9 mass%, N: 7.8 mass% (theoretical values: C: 55.3 mass%, H: 10.4 mass%, N: 8.1 mass%)
Chlorine: Less than 10 ppm

### (Example 3: Compound No. 14)

1.00 g (2.63 mmol) of bis(bis(trimethylsilyl)amino) cobalt (II) and 10 g of toluene were placed in a 100 mL three-necked flask, and 0.83 g (5.26 mmol) of 1-diethylamino)-3-methylbutan-2-ol was then added dropwise to the flask at room temperature. Following completion of the dropwise addition, the mixed liquid was stirred at room temperature for 20 hours. The target product (Compound No. 14), which was a deep purple viscous liquid, was obtained by removing the solvent and by-produced silazane compounds under reduced pressure at a bath temperature of 110°C. The quantity produced was 0.75 g, and the yield was 74%.

The obtained target product (Compound No. 14) was subjected to elemental analysis (metal analysis: ICP-AES). These results are shown below.
Cobalt 16.2 mass% (theoretical value: 15.7 mass%)
C: 57.5 mass%, H: 10.4 mass%, N: 7.9 mass% (theoretical values: C: 57.6 mass%, H: 10.7 mass%, N: 7.5 mass%)

### (Example 4: Compound No. 17)

1.00 g (2.63 mmol) of bis(bis(trimethylsilyl)amino) cobalt (II) and 10 g of toluene were placed in a 100 mL three-necked flask, and 0.87 g (5.26 mmol) of 1-(ethyl(methyl)amino)-4-methylpentan-2-ol was then added dropwise to the flask at room temperature. Following completion of the dropwise addition, the mixed liquid was stirred at room temperature for 20 hours. The target product (Compound No. 17), which was a deep purple viscous liquid, was obtained by removing the solvent and by-produced silazane compounds under reduced pressure at a bath temperature of 110°C. The quantity produced was 0.80 g, and the yield was 81%.

The obtained target product (Compound No. 17) was subjected to elemental analysis (metal analysis: ICP-AES). These results are shown below.
Cobalt: 15.4 mass% (theoretical value: 15.7 mass%)
C: 57.9 mass%, H: 10.6 mass%, N: 7.1 mass% (theoretical values: C: 57.6 mass%, H: 10.7 mass%, N: 7.5 mass%)

### (Example 5: Compound No. 22)

3.95 g (30.4 mmol) of cobalt (II) chloride and 29.1 g of tetrahydrofuran were placed in a 200 mL three-necked flask, and stirred at room temperature. A solution obtained by diluting 10.7 g (59.3 mmol) of a sodium alkoxide, which was obtained using 1-(ethyl(methyl)amino)-3-methylpentan-2-ol, with 28.9 g of tetrahydrofuran was added dropwise to the flask under ice cooling. Following completion of the dropwise addition, the mixed liquid was stirred at room temperature for 18 hours and then filtered. The target product (Compound No. 22), which was a purple viscous liquid, was obtained by removing the solvent from the obtained filtrate and distilling the residue at a bath temperature of 165°C, a pressure of 65 Pa and an overhead temperature of 147°C. The quantity produced was 1.42 g, and the yield was 13%.

The obtained target product (Compound No. 22) was subjected to elemental analysis (metal analysis: ICP-AES, chlorine analysis: TOX). These results are shown below.
Cobalt 15.2 mass% (theoretical value: 15.7 mass%)
C: 58.0 mass%, H: 10.8 mass%, N: 7.6 mass% (theoretical values: C: 57.6 mass%, H: 10.7 mass%, N: 7.5 mass%)
Chlorine: Less than 10 ppm

### (Example 6: Compound No. 27)

2.90 g (0.022 mol) of cobalt (II) chloride and 17.6 g of tetrahydrofuran were placed in a 100 mL three-necked flask, and stirred at room temperature. A solution obtained by diluting 7.97 g (0.044 mol) of a sodium alkoxide, which was obtained using 1-(ethyl(methyl)amino)-3,3-dimethylbutan-2-ol, with 15.6 g of tetrahydrofuran was added dropwise to the flask under ice cooling. Following completion of the dropwise addition, the mixed liquid was stirred at room temperature for 20 hours and then filtered. The target product (Compound No. 27), which was a dark red solid (melting point 69°C), was obtained by removing the solvent from the obtained filtrate and distilling the residue at a bath temperature of 135°C and a pressure of 17 Pa. The quantity produced was 3.39 g, and the yield was 41%.

The obtained target product (Compound No. 27) was subjected to elemental analysis (metal analysis: ICP-AES, chlorine analysis: TOX). These results are shown below.
Cobalt: 15.9 mass% (theoretical value: 15.7 mass%)
C: 57.9 mass%, H: 10.4 mass%, N: 7.6 mass% (theoretical values: C: 57.6 mass%, H: 10.7 mass%, N: 7.5 mass%)
Chlorine: Less than 10 ppm

### (Example 7: Compound No. 29)

5.95 g (45.8 mmol) of cobalt (II) chloride and 26.8 g of tetrahydrofuran were placed in a 200 mL three-necked flask, and stirred at room temperature. A solution obtained by diluting 17.2 g (88.3 mmol) of a sodium alkoxide, which was obtained using 1-(diethylamino)-3,3-dimethylbutan-2-ol, with 22.9 g of tetrahydrofuran was added dropwise to the flask under ice cooling. Following completion of the dropwise addition, the mixed liquid was stirred at room temperature for 16 hours and then filtered. The target product (Compound No. 29), which was a reddish purple viscous liquid, was obtained by removing the solvent from the obtained filtrate and distilling the residue at a bath temperature of 150°C, a pressure of 40 Pa and an overhead temperature of 115°C. The quantity produced was 7.59 g, and the yield was 43%.

The obtained target product (Compound No. 29) was subjected to elemental analysis (metal analysis: ICP-AES, chlorine analysis: TOX). These results are shown below.
Cobalt 14.4 mass% (theoretical value: 14.6 mass%)
C: 59.7 mass%, H: 10.7 mass%, N: 7.3 mass% (theoretical values: C: 59.5 mass%, H: 11.0 mass%, N: 6.9 mass%)
Chlorine: Less than 10 ppm

### (Comparative Examples 1 and 2)

Comparative Compound No. 1 was produced as Comparative Example 1 and Comparative Compound No. 2 was produced as Comparative Example 2 using well-known methods.

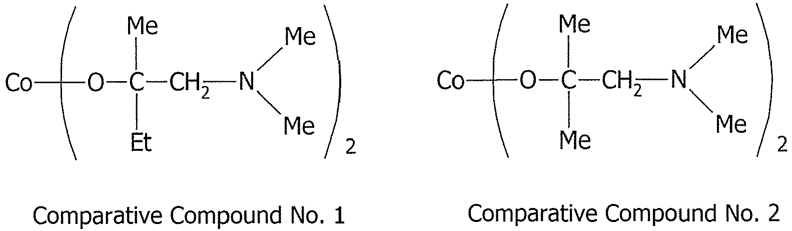

The cobalt compounds obtained in the examples and comparative examples described above were visually observed in terms of state at ordinary temperature (30°C) (whether the cobalt compound was in the form of a solid or liquid) and, in the case of a solid, the melting point was measured using a micro melting point apparatus.

In addition, the cobalt compounds obtained in the examples and comparative examples described above were evaluated in terms of thermal stability by measuring the temperature at which thermal decomposition occurred (the thermal decomposition onset temperature) using a DSC measurement apparatus.

In addition, the cobalt compounds obtained in the examples and comparative examples described above were subjected to TG-DTA at ordinary pressure and under reduced pressure, and the temperature at which the weight of the sample decreased by 50% was measured.

### <Measurement conditions for TG-DTA at ordinary pressure>

Ar flow rate: 100 mL/min
Rate of temperature increase: 10°C/min
Sample quantity: Approximately 10 mg

### <Measurement conditions for TG-DTA under reduced pressure>

Pressure: 10 Torr
Ar flow rate: 50 mL/min
Rate of temperature increase: 10°C/min
Sample quantity: Approximately 10 mg
The evaluation results are shown in Table 1.

**[Table 1]**

| | Type of compound | State at ordinary temperature | Melting point (°C) | Thermal decomposition onset temperature (°C) | TG-DTA at ordinary pressure (°C) | TG-DTA under reduced pressure (°C) |
|---|---|---|---|---|---|---|
| Example 1 | Compound No. 7 | Liquid | - | 240 | 251 | 195 |
| Example 2 | Compound No. 12 | Liquid | - | 230 | 237 | 157 |
| Example 3 | Compound No. 14 | Liquid | - | 240 | 544 | 158 |
| Example 4 | Compound No. 17 | Liquid | - | 260 | 259 | 197 |
| Example 5 | Compound No. 22 | Liquid | - | 240 | 238 | 170 |
| Example 6 | Compound No. 27 | Solid | 65 | 250 | 214 | 132 |
| Example 7 | Compound No. 29 | Liquid | - | 230 | 227 | 144 |
| Comparative Example 1 | Comparative Compound No. 1 | Solid | 80 | 300 | *2 | 150-170 |
| Comparative Example 2 | Comparative Compound No. 2 | Solid | > 100 | *1 | *2 | 150-170 |
| *1) Thermal decomposition onset temperature omitted due to high melting point | | | | | | |
| *2) TG-DTA measurements at ordinary pressure omitted due to high melting point or thermal decomposition onset temperature | | | | | | |

As shown by the results in Table 1, the cobalt compound of Comparative Example 1 had a melting point of 80°C and the cobalt compound of Comparative Example 2 had a melting point of 100°C or higher, whereas the cobalt compounds of Examples 1 to 7 all had lower melting points than the cobalt compounds of Comparative Examples 1 and 2. Of these, the cobalt compounds of Examples 1 to 5 and 7 were understood to be liquids at ordinary temperature and pressure. Because thin film-forming raw materials that are liquids or have a low melting point at ordinary temperature and pressure can be easily transported, it can be said that the cobalt compounds of Examples 1 to 7 are thin film-forming raw materials capable of improving productivity. In addition, the cobalt compound of Comparative Example 2 required heating to 300°C in order to undergo thermal decomposition, whereas it was confirmed that the cobalt compounds of Examples 1 to 7 could be decomposed at temperatures that were 20 to 30% lower than that required for the cobalt compound of Comparative Example 2. Of these, it was understood that the cobalt compounds of Examples 2 and 7 could be decomposed at a particularly low temperature, namely 230°C.

Furthermore, the cobalt compounds of Examples 1 to 7 had a low temperature at which the weight of a sample decreased by 50%, and can therefore be said to be thin film-forming raw materials having a high vapor pressure.

### (Example 8: production of cobalt oxide thin film by thermal CVD method)

Using the cobalt compounds of Examples 1 to 7 as thin film-forming raw materials, cobalt oxide thin films were formed on Cu substrates and SiO₂ substrates by means of a thermal CVD method using the CVD apparatus shown in Fig. 1 under the following conditions.

### <Conditions>

Raw material container temperature: 70°C
Pressure inside raw material container: 100 Pa
Reaction temperature (substrate temperature): 300°C
Reactive gas: None
Carrier gas: Argon gas

### <Process>

The vaporized thin film-forming raw material was supplied to a film formation chamber and deposited for a period of 8000 seconds at a pressure of 100 Pa inside the film formation chamber.

The obtained thin film was measured in terms of film thickness using an X-ray reflectance method, and the structure and composition of the thin film were confirmed using an X-ray photoelectron spectroscopy. The results showed that the film thickness obtained per unit time was 0.2 to 1.0 nm/min, and that the obtained thin films were all cobalt oxide thin films.

As can be seen from the results above, according to this invention, it is possible to provide a cobalt compound which can be transported in the form of a liquid due to having a low melting point, which can be decomposed at a low temperature and which can be easily vaporized due to having a high vapor pressure; and a thin film-forming raw material that uses this cobalt compound. According to this invention, it is also possible to provide a thin film production method by which a high quality cobalt-containing thin film can be produced with good productivity.

Moreover, the present international application claims priority on the basis of Japanese Patent Application No. 2014-100607, which was filed on 14 May 2014, and all the details of that application are incorporated in the present international application.

## Claims

1. A cobalt compound represented by general formula (I): 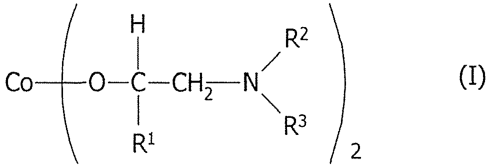 wherein R¹ to R³ independently represent a straight chain or branched alkyl group having 1 to 5 carbon atoms.

2. A thin film-forming raw material, comprising the cobalt compound according to claim 1.

3. A method for producing a thin film, comprising the steps of:
vaporizing the thin film-forming raw material according to claim 2 to obtain a cobalt compound-containing vapor; and
contacting the vapor with a substrate to decompose and/or chemically react the cobalt compound and then to form a thin film on the substrate.
